Europäisches Patentamt

European Patent Office

Office européen des brevets

(11) Publication number: **0 387 845**
**A1**

# (12) EUROPEAN PATENT APPLICATION

(21) Application number: 90104831.4

(22) Date of filing: **14.03.90**

(51) Int. Cl.5: **H05K 7/02**

(30) Priority: **15.03.89 US 324162**

(43) Date of publication of application:
**19.09.90 Bulletin 90/38**

(84) Designated Contracting States:
**DE FR GB IT NL**

(71) Applicant: **AMP INCORPORATED**
**470 Friendship Road**
**Harrisburg Pennsylvania 17105(US)**

(72) Inventor: **Bates, Warren Anton**
**3345 Nottingham Road**
**Winston-Salem, North-Carolina 27104(US)**

Inventor: **Stillie, Donald Gray**
**4912 Stonington Road**
**Winston-Salem, North-Carolina 27103(US)**
Inventor: **Kunkle, John Philip**
**157 Roquemore Road**
**Clemmons, North-Carolina 27012(US)**
Inventor: **Zutaut, Donald James**
**Route 6, Box 388A**
**Winston-Salem, North-Carolina 27107(US)**

(74) Representative: **Klunker . Schmitt-Nilson .**
**Hirsch**
**Winzererstrasse 106**
**D-8000 München 40(DE)**

(54) **Reaction injection molded electrical distribution apparatus.**

(57) A circuit panel or electrical distribution box (2) suitable for use in an appliance is disclosed. The electrical distribution box comprises a lead frame (4) at least partially emtedded within an insulative body (6) formed of a reaction injection material molded around the lead frame. The electrical distribution box (2) provides interconnections between harnesses and components, such as transformers and relay coils, in an appliance, such as an electric dryer. Traces formed by severing the lead frame (4) extend between exposed termination points at which interconnection tabs (8), including power tabs (L1, N, L2), are located.

Fig. 1

## REACTION INJECTION MOLDED ELECTRICAL DISTRIBUTION APPARATUS

This invention relates to an electrical distribution apparatus for interconnecting a plurality of wires and components in which traces are partially imbedded within an insulative body formed of a reaction injection molded plastic. More specifically, this invention relates to an electrical distribution box or panel for use in an appliance such as a dryer, to form a central electrical interconnection point for a plurality of harnesses and components. The electrical distribution box or panel is formed by an insert molding process in which a lead frame is imbedded within a reaction injection molded material formed by injecting two materials into a mold chamber at low pressure.

Electrical harnesses are typically made of electrical conductor wires which are mostly individually, stranded, and insulated wires with an occasional uninsulated stranded or solid wire utilized for grounding or the like. These wires are typically terminated by electrical terminals and/or connectors and formed into some general shape suitable for inventory and handling by the use of tape or harness ties. Fasteners may or may not be employed to affix the harness to the apparatus in which the harness is used. The harness wires serve the function of supplying power to the various components of such apparatus or signals for either control or machine intelligence purposes and, as mentioned, ground and/or shielding circuit functions. The harness may be a simple one, having only several short wires but a few inches in length utilized to interconnect the components of a simple circuit in an apparatus such as a camera or smoke alarm or, it may have literally hundreds of wires terminated in very expensive connectors and utilized to interconnect all of the different devices and components of a complex circuit as in an aircraft. The harness constitutes a subassembly to be loaded into the apparatus on a production line as, for example, with respect to appliances such as washers, dryers, copy machines, stoves, refrigerators and the like; or, added piece-meal as the apparatus moves along a production line. Generally speaking, a harness is a flexible assembly having a non-rigid shape, such as a plurality of discrete wires which are bundle tied together and terminated at ends thereof for interconnection to a panel or other end components. These harnesses are difficult to handle by machine, making it difficult to automate either harness making or harness handling. Installation errors are common. This fact has frustrated industry for decades and, notwithstanding substantial efforts to automate or robotize harness making or harness manipulation, most harnesses are currently manufactured and installed in a highly labor intensive manner which impacts not only on cost but also on quality.

U. S. Patent 4,820,189 discloses a method ans apparatus for simplifying the wiring of an appliance such as a washer, dryer, copy machine, stove, refrigerator or the like. That application teaches a method of forming electrical wiring harnesses by implanting electrical wires into grooves in a panel laid out in a geometry or pattern suitable to effect wire distribution in the appliance. The panel can be formed from various materials including reaction injection molded plastics. The wires are terminated as desired by using an insulation displacement contact mounted in an insulated body which engages the wires as the wires are rolled in grooves past the insulation displacement contact. However, a single appliance may require a large number of different connectors.

U.S. Patent 4,387,509 discloses a method of manufacturing an electrical interconnection assembly such as an automobile harness junction box by laying a wire in a groove in a substrate. The wire in the grove is cut into a plurality of pieces which are then transferred from the groove onto terminals carried by an insulation support to form an assembly.

U.S. Patent 4,659,157 discloses a circuit assembly in which an integral metal stamping, having a plurality of conductors, is positioned within or pressed into complimentarily shaped recesses of a dielectric substrate or plastic substrate. That stamping has a plurality of upstanding male contacts overlying and coextensive with a support wall on the substrate to form a plug connector which can be received within a cavity of a mating female receptacle connector. The conductors are not encapsulated within the dielectric substrate for dimensional stability and support. Furthermore, this apparatus is not especially suitable for use with relatively small, densely packaged circuits.

Insert molded connectors in which terminals or lead frames are at least partially imbedded within a conventional plastic material also comprise the part of the prior art. These insert molded switches, connectors and receptacles are manufactured using conventional engineering plastics molded around stamped inserts. Insert molded switches, connectors and receptacles can then be employed within harnesses.

Other discrete components can also be manufactured using a technology referred to as three dimensional or multi-layer molded circuit design. Conventional three dimensional printed circuit boards are based upon an additive metalization process. For applications requiring large currents, for example 5 amps or greater in appliances, adequate conductive material thickness cannot economically be provided. Devices incorporating printed circuit boards or assembled switching circuits have been manufactured in a single molded part.

The instant invention comprises a central electrical distribution apparatus for use in an assembly to interconnect either a plurality of several electrical harnesses or a plurality of electrical components or a combination of harnesses to components. This invention is especially useful in an electrical appliance such as a washer or dryer. This apparatus facilitates fool proof wiring of harnesses and components in such an appliance. In a preferred embodiment, this apparatus comprises the central electrical connection point for harnesses and a plurality of components in an appliance. Separate harnesses, extend from this central electrical distribution apparatus to remote locations and remote components of the appliance. For example, the door switch on a dryer would be attached to the central distribution apparatus by a unique harness.

This central distribution apparatus includes a plurality of electrical traces partially embedded within an insulative body. Each trace has an exterior location or termination point located on the insulative body in a position in which it can be interconnected to an electrical connector or harness, or in a position to make contact with an electrical component mounted directly on the central distribution apparatus. The central electrical distribution apparatus is formed by mixing reactive materials in surrounding relationship to the traces disposed within a mold. The reactant materials solidify to form an insulative body. In the preferred embodiment of this invention the stamped lead frame is positioned within a mold and the reactive materials are injected into the mold at low pressure. Portions of the traces protrude from the insulative body at termination points so that interconnection can be made using standard electrical connectors. In the preferred embodiment of this invention these termination points comprise tabs, generally on the end of lead frame traces, which are deformed upwardly and located within receptacle openings for engagement with connectors on a harness. The connectors can be received within these receptacle openings. Latching means, normally in the form of recesses in the insulative body can be provided adjacent to receptacle openings so that the connectors can be secured to the housing to ensure that adequate electrical contact is made between the tabs on the lead frame and the contacts in the electrical harness.

The invention will now be described by way of example with reference to the accompanying drawings in which:

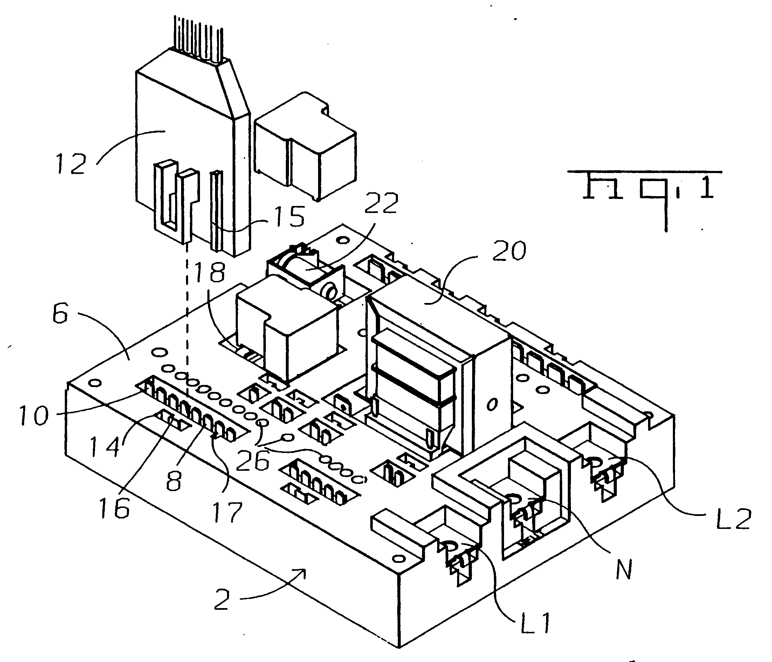

Figure 1 is a perspective view of a central distribution apparatus.

Figure 2 is a circuit diagram showing a circuit which could be used in a dryer in which the central electric distribution apparatus of the preferred embodiment of this invention could be used.

Figure 3A is a perspective view of a stamped and formed lead frame which can be employed to make all of the connections indicated by the circuit shown in Figure 2.

Figure 3B is a view, based upon Figure 3A showing the configuration of the traces after removal of the interconnecting tabs. Figure 3B is illustrative only, since the tabs are removed only after the insulative body is insert molded around a lead frame.

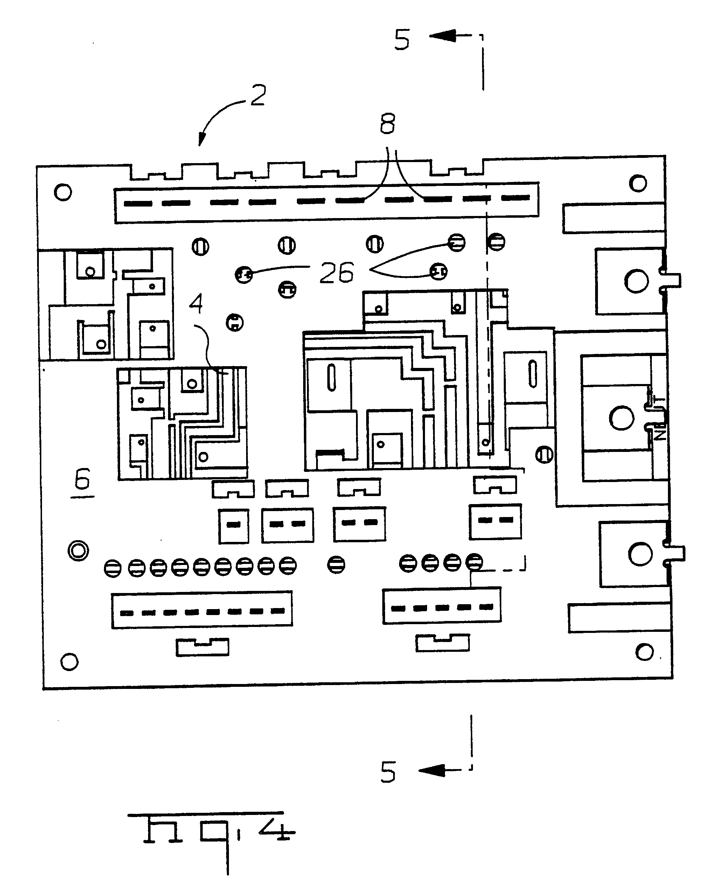

Figure 4 is a plan view of the central electrical distribution apparatus.

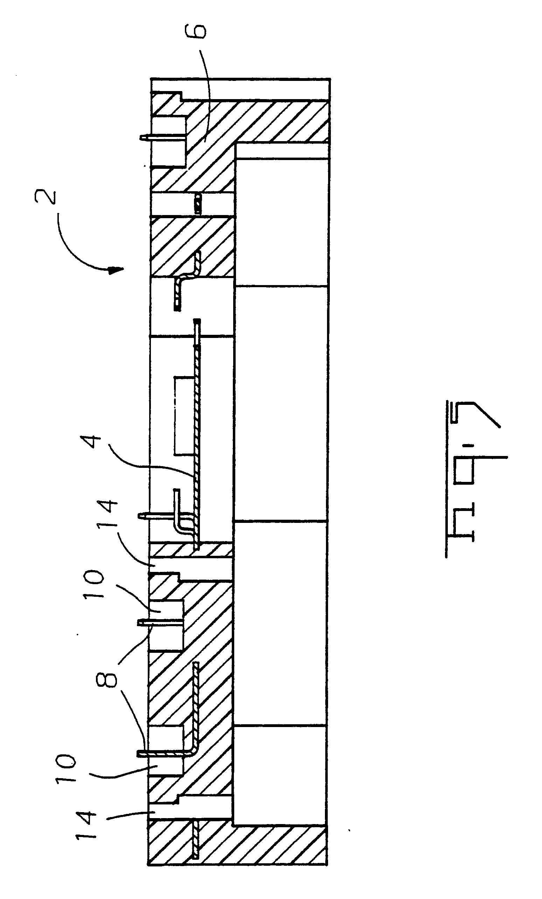

Figure 5 is a section view taken along section lines 5-5 of Figure 4.

Figure 6 is a schematic drawing depicting the reaction injection molding process.

Figure 7 is a schematic of an appliance in which the central electrical box is used.

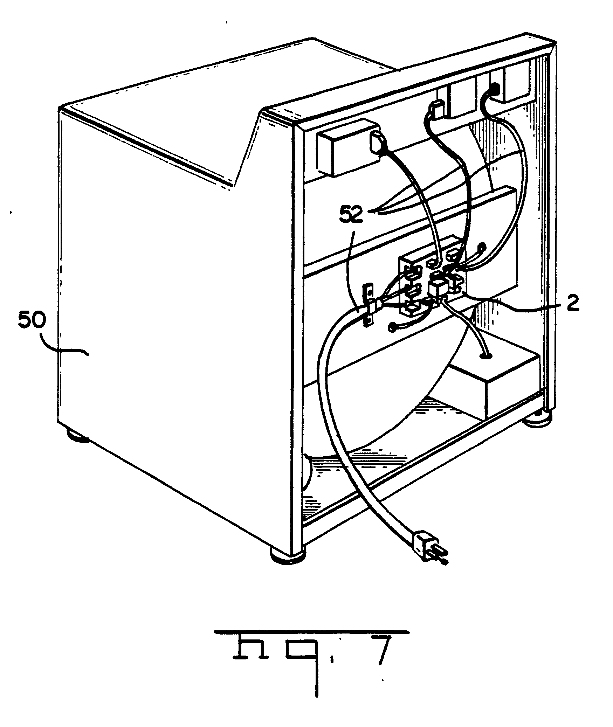

The preferred embodiment of the invention depicted here comprises a central electrical distribution box 2 for use in a dryer or appliance 50, or the like, as shown in Figure 7. This central electrical distribution box or apparatus 2 is formed from a lead frame 4 which is at least partially embedded within an insulative body 6. In the preferred embodiment the lead frame 4 is stamped from a conventional copper based alloy, however, the lead frame 4 may be composed of discrete conductors, such as wires, arranged in a desired pattern. In the preferred embodiment of this invention this insulative body 6 is formed from a reaction injection molded material formed by the reaction of at least two reactive materials, which are reactive after injection into the mold, into surrounding relationship with the lead frame 4. This reaction injection molding process uses materials which can be injected into a mold at comparatively low pressures. This low pressure is especially significant for large components such as this central electric distribution box. The preferred embodiment of the insulative body 6 is six inches (about 15 cm) long by 5 inches (about 13 cm) wide. A nominal height for the insulative body 6 is 1.125 inches (about 3 cm). If a conventional engineering thermoplastic were injected at high pressure into a mold, the position of the numerous contacts cannot be precisely held as the high pressure melt is injected into the mold. Furthermore, with conventional insert molding processes, the position of the termination points in the lead frame will also be significantly distorted as the plastic melt cools. Large, expensive molding presses would be required to insert mold conventional engineering thermoplastic for insulative parts large enough to serve as an electrical distribution apparatus. A mold press of between five hundred and one thousand tons would be required to insert mold a thermoplastic insulative body having the dimensions of the preferred embodiment of this invention.

Portions of the traces or conductors in the lead frame 4 remain exposed so that wires or components can be attached. Tabs 8, which have been formed upwardly, relative to the plane of the lead frame, comprise termination points for a plurality of the traces in the lead frame. In the preferred embodiment of this invention a plurality of tabs are positioned within receptacle openings extending inwardly from the upper face of the insulative body. The tabs 8 are spaced from the sidewalls of the various receptacle openings 10. Each receptacle opening is dimensioned to receive a suitable connector 12 on the end of harness wires. In the preferred embodiment of this invention, connectors 12 having different numbers of positions are used to preclude inadvertent errors in wiring the harness to the central distribution assembly. Latch recesses 14 having stop shoulders 16 can be positioned adjacent the receptacle openings 14. These latch recesses serve to receive and engage a conventional latch formed on the body of the housings of the connectors 12. Connector 12 can also be provided with a polarization rib 15 which can be received in a companion polarization slot on one side of a receptacle opening 10. Thus only properly polarized connector could be received within respective receptacle openings.

In addition to the termination tabs 8 connectable to wires in electrical harnesses 52, component mounting flanges 18 can also be provided in openings of the upper surface of the insulative housing 6. In general these component mounting flanges 18 are parallel to and spaced from the plane of the lead frame. Leads from components, such as transformer 10 or coils 22 engage the appropriate mounting flanges 18. The leads can be connected to these mounting flanges by conventional means, such as soldering.

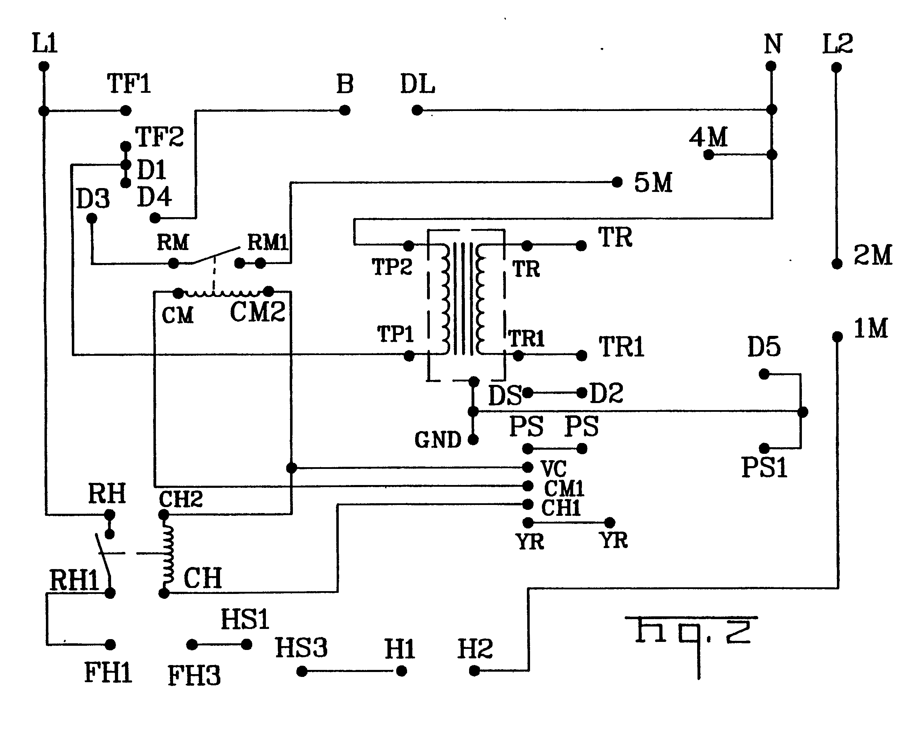

A circuit which can be used to interconnect and deliver power to the various components of an electric dryer is shown in Figure 2.

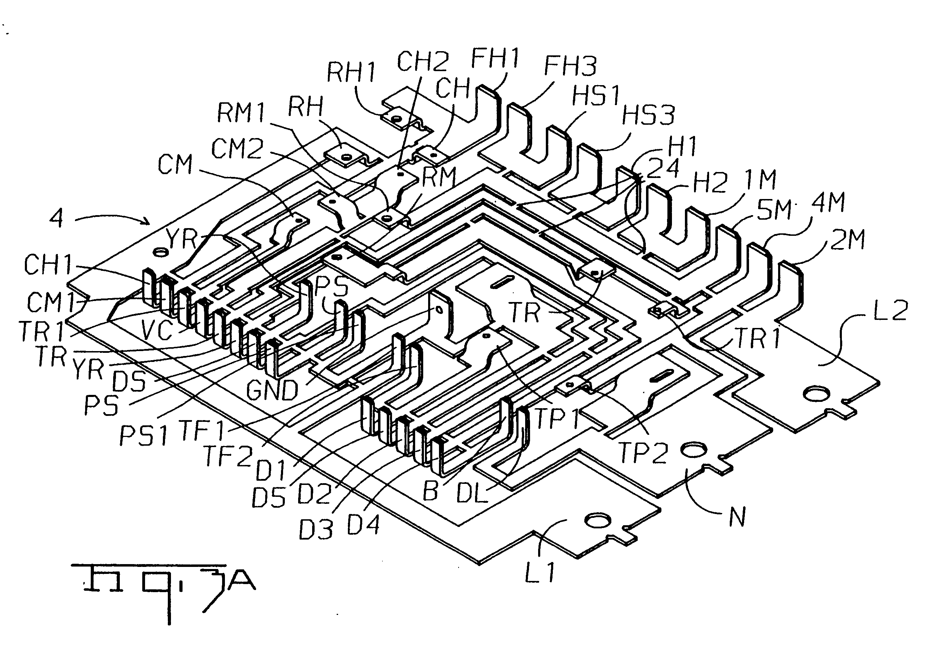

Figure 3A shows a stamped lead frame suitable for forming all of the interconnections needed to form the circuit of Figure 2. All of these interconnectors are included in a single electric distribution box. Corresponding symbols have been used for corresponding interconnection points on Figures 2 and 3A. The following table identifies the appropriate symbol for each component to be interconnected by the electrical distribution apparatus:

| | |
|---|---|
| Controls on Backsplash | CH1, CM1, VC, TR1, TR, YR, D5, P5 |
| Pressure Switch PS, PS1 (Lint Sensor) | |
| Ground | GND |
| Thermal Fuse | TF1, TF2 |
| Door Switch | D1, D2, D3, D4, D5 |
| Drum Lamp | B, DL |
| Line Voltage | L1 |
| Transformer Primary Winding | TP1, TP2 |
| Neutral | N |
| Line Voltage | L2 |
| Centrifugal Switch on Motor | 1M, 2M |
| Motor Windings | 4M, 5M |
| Transformer Secondary Winding | TR, TR1 |
| Heater | H1, H2 |
| High Limit Thermostat | 4S1, 4S3 |
| Heater Box Thermal Cutoff | FH1, FH3 |
| Heater Relay Coil | CH, CH2 |
| Heater Relay Contacts | RH, RH1 |
| Motor Relay Coil | RM, RM1 |
| Motor Relay Coil | CM, CM2 |
| Humidity Sensor | YR |

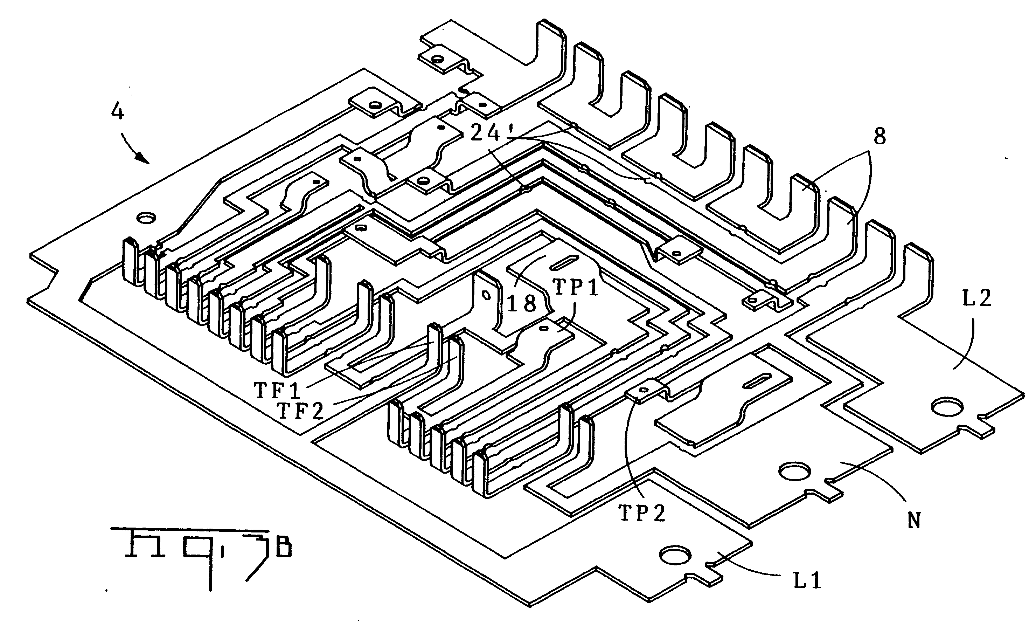

A reaction injection molded insulative body is formed around the lead frame 4 as shown in Figure 3A after the lead frame is positioned within a mold. After the lead frame is encapsulated in the insulative body in the mold, segments 24 of the lead frame which hold the various components together prior to and during molding, but which serve no electrical function, can be removed. Holes 26 aligned with these segments are molded within the insulative body. After these segments 24 are punched out, a plurality of traces forming the interconnections required by the circuit shown in Figure 2 is provided. These traces are illustrated in Figure 3B. It should be understood, that in the preferred embodiment of this invention, the traces would only be separated in the manner illustrated in Figure 3B after the reaction injection molded insulative body is formed around the lead frame 4. Figure 3B is therefore illustrative only. The insulative body 6 is not shown in Figure 3B so that the separate traces may be shown. Representative locations where tabs 24 have been removed by punching or stamping are identified by the numeral 24' in Figure 3B. In the case where the lead frame is composed of discrete conductors, such as wires, the segments 24 may be attached to, and space the conductors.

The interconnection between the electrical power, a thermal fuse and the transformer primary winding should be sufficient to demonstrate the manner in which this central electrical distribution box interconnects harnesses and components, such as transformer 20. As shown in Figure 2, line voltage at L1 is delivered to primary transformer winding TP1 through a thermal fuse having connections TF1 and TF2. Figure 3B shows that power tab L1 is connected directly to termination tab TF1. A harness leading to a thermal fuse can be attached to termination tabs TF1 and TF2 with the line voltage from L1 being delivered through the thermal fuse. A separate trace embedded within the insulative body now leads from termination tab TF1 to the transformer primary winding tab TP1. The transformer is soldered to the tab TP1 with line voltage now being delivered to the transformer primary winding at tab TP1. Note that transformer winding tab TP2 is connected to the neutral power tab N.

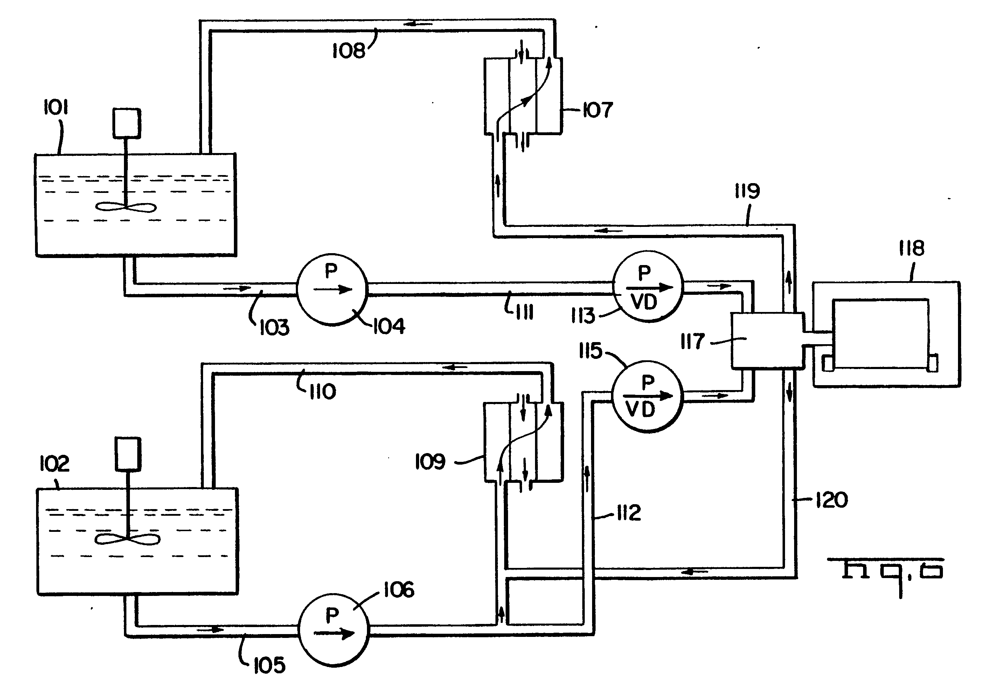

A reaction injection molding (RIM) process which can be employed in the fabrication of an apparatus, such as that employed in the preferred embodiment of this invention is shown in Figure 6. Separate reactants are contained within feed tanks 101 and 102. Each of the reactants is fed along lines 103 and 105 respectively by low pressure circulating pumps 104 and 106 respectively. The reactants are then fed respectively through lines 112 and 111 to metering pumps 113 and 115. The reactants, still separate, are then fed along lines 114 and 116 to a mix head 117 where the reactants are intermixed at relatively high pressures. For example, the liquid reactants can enter the mix chamber in the mix heads at pressures of between 1000, 1500 and 3000 psi (about 69, 103 and 207 bar) where they are statically mixed by high velocity impingement. From the mix chamber 117, the reactants can then flow into the cavity in mold 118, where an exothermic reaction occurs in which the reactants expand to occupy a larger volume as a reactant product than occupied by the reactants separately. The reactive products although intermixed enter the mold cavity in a liquid form having a density which is substantially less than the density of a thermoplastic in a conventional molding operation. The reactants can thus completely fill the mold cavity. The relatively high pressures needed for conventional thermoplastics is not required.

The reaction injection molding process shown in Figure 6 involves the intermittent injection of the reactants into mold 18. The mix head 117 includes a valve which permits the reactants, while still separate, to be recirculated through lines 110 and 120, heat exchangers 107 and 109 and return lines 108 and 110 to respective feed tanks 101 and 102 for continuous recirculation. A Cannon 8 C 40/2 RIM molding machine can be employed.

Depending upon the specific requirements of the specific apparatus, a plurality of potential materials are available for fabricating the insulative body. Urethane or polyurethene reaction injection plastics can be employed. Materials which could be employed include Nyrim which comprises nylon block copolymers which can be reinforced with glass fiber, flake or prepolymer combined with caprolactam monomer. Nyrim is a trademark of Monsanto Company. Another material which evidences a high degree of rigidity is General Latex XR/992R which can be used for high density molding pour in place operations and is available from General Latex and Chemical Corporation.

## Claims

1. A circuit panel (2) comprising;
a plurality of electrical traces, each trace extending between spaced exterior locations on a reaction injection molded insulative body (6), the insulative body (6) being formed of a reaction injection molded material formed of at least two materials reactive in surrounding relationship to the traces, the reaction injection molded insulative body (6) being molded at least partially around each of the traces to hold the traces in position, each trace having means for termination (8) to a circuit element (CH1, YR, etc.) located at the spaced exterior location on the insulative body (6).

2. The circuit panel of claim 1 wherein the plurality of electrical traces are included in a stamped and formed lead frame (4).

3. The circuit panel of claim 2 wherein the stamped and formed lead frame (4) is embedded within the insulative body (6) except at the spaced exterior locations (10).

4. The circuit panel of claim 3 wherein that portion of the stamped and formed lead frame (4) embedded within the insulative body (6) lies in the same plane, except immediately adjacent the spaced exterior locations (10).

5. The circuit panel of any of claims 1 to 4 wherein the major portion of the insulative body (6) is substantially flat and at least a portion of the spaced exterior locations (10) are located on the periphery of the insulative body.

6. The circuit panel of any of claims 2 to 5 wherein the means for termination to a circuit element comprise tabs (8) extending at an angle relative to the remainder of the lead frame (4).

7. The circuit panel of any of claims 1 to 6 wherein the spaced exterior locations comprise receptacle openings (10) suitable for receiving an electrical connector (12), the tabs (8) extending into the openings.

8. The circuit panel of claim 7 wherein latch recesses (14) are formed adjacent the receptacle openings (10).

9. The circuit panel of any of claims 1 to 8 wherein the reaction injection molded insulative material comprises a urethane material.

10. The circuit panel of any of claims 1 and 5 to 9 wherein the traces comprise discrete electrical conductors.

Fig.1

Fig. 2

EP 0 387 845 A1

RH1  CH2  FH1  FH3
RM1  RH  CH  HS1
CM2  RM  HS3
CM  H1
4  YR  24  H2  1M
CH1  5M  4M
CM1  2M
TR1  VC  PS  TR  L2
TR  YR  TR1
YR  DS  PS
PS  GND
PS1  TF1  TP1
TF2  D1  TP2  N
D5  D2  B  DL
D3  D4  L1

Fig. 7A

EP 0 387 845 A1

Fig. 4

Fig. 7

Fig.6

50

52

2

Fig. 7

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4629823 (FUSHIYA ET AL) <br> * column 4, lines 9 - 36 * <br> --- | 1, 10 | H05K7/02 |
| Y | EP-A-0241675 (PREH) <br> * the whole document * <br> --- | 1, 10 | |
| A | EP-A-0282797 (SCHAFFNER ELEKTRONIK AG) <br> * column 6, lines 40 - 56 * <br> --- | 2-4 | |
| A | US-A-4781621 (SUGIYAMA ET AL) <br> * column 1, lines 27 - 41 * <br> --- | 1 | |
| A | DE-C-3608752 (OSSENBERG) <br> * column 3, line 58 - column 4, line 15 * <br> --- | 1 | |
| A,D | EP-A-0216466 (MOLEX INCORPORATED) <br> * column 4, lines 19 - 41 * <br> ----- | 1 | |
| | | | **TECHNICAL FIELDS SEARCHED (Int. Cl.5)** |
| | | | H05K |

The present search report has been drawn up for all claims

| Place of search | Date of completion of the search | Examiner |
|---|---|---|
| THE HAGUE | 30 MAY 1990 | TOUSSAINT F.M.A. |